# EUROPEAN PATENT APPLICATION

(11) **EP 4 478 852 A1**
(43) Date of publication of application: **18.12.2024**
(21) Application number: 24174741.9
(22) Date of filing: 08.05.2024
(51) Int. Cl.: H05K 7/20, F28F 3/12

(54) **HEAT EXCHANGER**

(30) Priority: 07.06.2023 GB 202308443
(71) Applicant: Rolls-Royce plc, London N1 9FX (GB)
(72) Inventor: Gorla, Daniele M, Derby, DE24 8BJ (GB)
(74) Representative: Rolls-Royce plc

(57) **Abstract**

The disclosure relates to a heat exchanger (201) for a cooling system (200), the heat exchanger (201) comprising: a first part (301) having a first surface (203) for connecting to a component (202) to be cooled and a second opposing surface (304), the first part (301) having a fluid flow channel (305) extending from a fluid inlet (210) through the first part (301) between the first and second surfaces (203, 304); a second part (307) extending from the second surface (304) to an external third surface (211), the second part (307) having an open-cell porous structure in fluid communication with the fluid flow channel (305) such that fluid flowing through the fluid flow channel (305) passes into the second part (307) and exits the heat exchanger (201) at the external third surface (211).

## Description

### TECHNICAL FIELD

The disclosure relates to a heat exchanger for a cooling system, a cooling system incorporating the heat exchanger and a method of operating such a cooling system.

### BACKGROUND

Power electronics, such as inverters and rectifiers, DC-DC converters and solid-state power controllers (SSPCs), are increasingly being used for civil and defence aircraft applications to manage and convert large quantities of electric power flowing from generators, batteries and fuel cells, and used by electric motors and various other electrical loads.

Although modern power electronics work with very high levels of efficiency, large quantities of heat are still produced due to the amount of power being managed for their size. This heat needs to be transferred away from the electronics to prevent overheating.

Cooling systems may use two-phase immersion cooling, in which electronic components are immersed and cooled by a liquid-phase dielectric refrigerant. The refrigerant may be maintained close to its liquid saturation line or subcooled. The heat generated by the electronic components is dissipated by the liquid refrigerant. The temperature of the liquid may be maintained by the proximity to its boiling point. Vapourised liquid is transported to a condenser, where heat is removed and the vapour transformed back to a liquid, which is fed back to the liquid bath in which the components are immersed.

Advantages of two-phase immersion cooling include: the ability to passively pump refrigerant; no thermal interface being required with the components; the refrigerant being non-flammable and electrically insulating; low-precision packaging; no need for heat sinks; and a uniform temperature and heat flux being maintained.

A known problem in two-phase immersion cooling systems is that of "critical heat flux" at the refrigerant/component surface interface. This occurs where bubbles that nucleate during heating increase in size and remain in contact with the component. This may result in a sudden decrease in the efficiency of heat transfer, causing localised overheating. In normal operation, vapour bubbles that form at the surface will tend to move away from the interface between the coolant and the component due to their buoyancy. However, it may not be possible to rely on buoyancy in some aerospace applications due to variable accelerations. This may allow bubbles of gas that locally form to increase in size and accumulate. This can be a particular concern in upcoming VTOL and high-performance aircraft, which may be subjected to temporary zero-g, negative-g or variable direction accelerations. This problem can be exacerbated by the fact that transient accelerations can also involve transient conditions in the power electronics (e.g., increased power transfer), resulting in higher heating and a potential reduction in cooling efficiency at a time when increased cooling is required.

### SUMMARY

According to a first aspect there is provided a heat exchanger for a cooling system, the heat exchanger comprising:
a first part having a first surface for connecting to a component to be cooled and a second opposing surface, the first part having a fluid flow channel extending from a fluid inlet through the first part between the first and second surfaces;
a second part extending from the second surface to an external third surface, the second part having an open-cell porous structure in fluid communication with the fluid flow channel such that fluid flowing through the fluid flow channel passes into the second part and exits the heat exchanger at the external third surface.

The fluid flow channel may extend from the fluid inlet in a direction parallel to the first and second surfaces. In other words, an axis of the fluid flow channel and a direction normal to the first, second and third surfaces may be mutually perpendicular.

The heat exchanger may comprise a plurality of fluid passages connecting the fluid flow channel to the second part. Each of the plurality of fluid passages may comprise a branching diffusion channel extending into the second part. A diameter of each of the fluid passages may be smaller than a diameter of the fluid flow channel. Each of the fluid passages may comprise a nozzle configured to cause an isenthalpic pressure drop in liquid refrigerant passing through the nozzle. The nozzle may be in the form of a convergent-divergent nozzle.

According to a second aspect there is provided a cooling system comprising:
a tank for containing a refrigerant liquid;
a heat exchanger according to the first aspect disposed in the tank;
a refrigerant pump having an outlet connected to the fluid inlet of the heat exchanger and an inlet connected to a liquid outlet of the tank to receive liquid refrigerant from the tank; and
a component to be cooled connected to the first surface of the heat exchanger.

The cooling system may comprise a condenser disposed in the tank and connected to a cooler arranged to extract heat from the tank via the condenser.

The cooling system may comprise a gas-to-liquid separator connected between the inlet of the pump and the liquid outlet of the tank.

The cooling system may comprise a temperature sensor and a pressure sensor connected to respectively measure temperature and pressure of liquid in an outlet line connecting the pump to the heat exchanger.

The cooling system may comprise a control unit configured to control operation of the pump.

The cooling system may comprise a control unit configured to control operation of the condenser to control a rate of heat transfer between the liquid refrigerant and the condenser.

The control unit may be configured to receive temperature and pressure readings from the temperature and pressure sensors.

According to a third aspect there is provided a method of operating a cooling system comprising:
a heat exchanger according to the first aspect;
a refrigerant pump having an outlet connected to the fluid inlet of the heat exchanger; and
a component to be cooled connected to the first surface of the heat exchanger,
the method comprising operating the refrigerant pump to pump refrigerant liquid into the heat exchanger.

The system may comprise a control unit for controlling the operation of the refrigerant pump. The method may comprise controlling a mass flow rate delivered by the pump.

The heat exchanger may be disposed in a tank containing the refrigerant liquid, the refrigerant pump having an inlet connected to a liquid outlet of the tank to receive refrigerant liquid from the tank.

The heat exchanger may be fully or partially immersed in the refrigerant liquid.

The cooling system may comprise a condenser disposed in the tank and connected to a cooler operating to extract heat from the tank via the condenser.

The cooling system may comprise a control unit for controlling the operation of the condenser. The method may comprise controlling a rate of heat transfer between the condenser and the refrigerant liquid. For example, the control unit may control a mass flow rate of a liquid supplied by a pump of the condenser and/or control a temperature of the liquid.

The method may comprise, responsive to an increase in a rate of heat generation by the component, the control unit increasing a mass flow rate delivered by the refrigerant pump and increase a rate of heat transfer between the condenser and the refrigerant liquid.

The method may comprise controlling, by the control unit, the mass flow rate delivered by the refrigerant pump and the rate of heat transfer between the condenser and the refrigerant liquid to control a downstream pressure of the heat exchanger and thereby control an evaporation temperature of the refrigerant liquid.

The cooling system may comprise a gas-to-liquid separator connected between the inlet of the pump and the liquid outlet of the tank.

The cooling system may comprise a temperature sensor and a pressure sensor connected to measure temperature and pressure of liquid in an outlet line connecting the pump to the heat exchanger.

The cooling system may comprise a control unit that receives temperature and pressure readings from the temperature and pressure sensors and controls operation of the pump.

The control unit may control operation of the pump to maintain the refrigerant in the outlet line in liquid phase.

The refrigerant passing through or exiting from the heat exchanger may be a two-phase liquid and gas mixture.

The skilled person will appreciate that except where mutually exclusive, a feature described in relation to any one of the above aspects may be applied mutatis mutandis to any other aspect. Furthermore, except where mutually exclusive any feature described herein may be applied to any aspect and/or combined with any other feature described herein.

### BRIEF DESCRIPTION OF THE DRAWINGS

Embodiments will now be described by way of example only with reference to the accompanying drawings, which are purely schematic and not to scale, and in which:
**FIG. 1** is a schematic pressure-enthalpy diagram for a refrigerant;
**FIG. 2** is a schematic diagram of an example cooling system comprising an immersed heat exchanger;
**FIG. 3** is a schematic diagram of an example heat exchanger for the cooling system of FIG. 2 but disposed in a horizontal orientation;
**FIG. 4** is a schematic diagram of an example form of pressure and flow management system for the cooling system of FIG. 2;
**FIG. 5** is a schematic diagram of an alternative configuration of the example cooling system of FIG. 2; and
**FIG. 6** is a further schematic pressure-enthalpy diagram for a refrigerant.

### DETAILED DESCRIPTION

Described herein is a heat exchanger, or evaporator, for use in cooling systems, in particular for immersion cooling systems and vapour compression refrigeration cycle cooling systems. Immersion cooling is currently employed in static applications, such as in data centres. Immersion cooling may also be applied to some mobile applications, for example for electric vehicle battery cooling, but is not generally applied to aerospace applications due to the above-mentioned problems, although liquid cooling may be used when employed in a closed loop sealed system.

The heat exchanger has particular advantages in mobile systems, such as in aerospace applications, where there may be transient or extended accelerations with zero-g, variable-g or negative-g. A cooling system incorporating such a heat exchanger may for example be used to cool power electronics components.

The heat exchanger includes a thermally conductive body to which the component to be cooled (e.g., power electronics) can be thermally coupled. A refrigerant fluid flow channel is provided through the thermally conductive body. A pressure and flow management system may be configured to control a pressure and flow rate of liquid refrigerant flowing through the channel.

The pressure and flow management system may control the flow of liquid refrigerant through the channel to maintain a desired temperature of the thermally conductive body. This helps to prevent bubbles being retained at the thermal interface between the heat exchanger and the refrigerant, which can otherwise result in a sudden drop in the efficiency of heat transfer and thus loss of cooling. These bubbles would normally move away from the interface due to buoyancy, but in the presence of transient accelerations or in the case of low gravity the bubbles can be retained at the interface.

The principle of operation of the heat exchanger relies on using a pressure drop between the tank, in which the heat exchanger is disposed, and the refrigerant flowing through the channel in the heat exchanger. This produces a refrigerant flow across the heat exchanger to maintain the source temperature controlled over a wider range of operating conditions. If applied to an immersion cooling system, which does not usually include an evaporator, implementing the heat exchanger will require sacrificing some advantages of conventional immersion cooling systems, but with the advantage of reducing the possibility of reaching the critical heat flux during certain operating conditions.

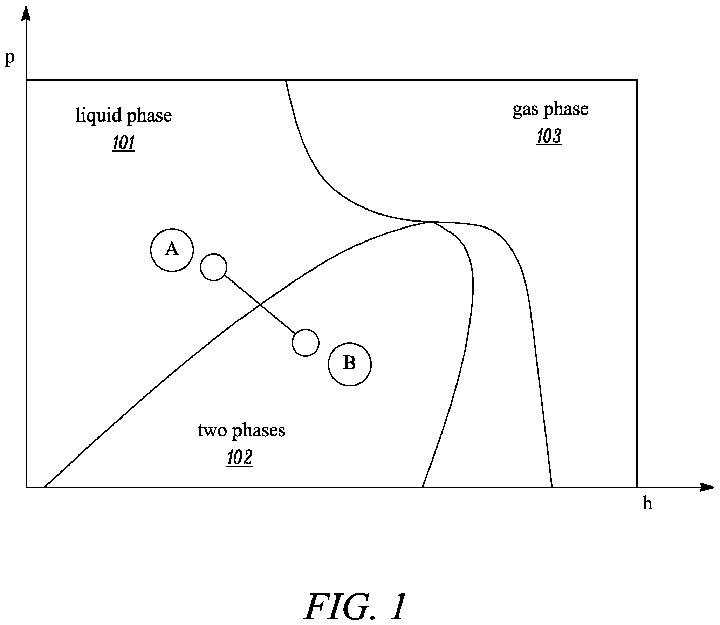

The refrigerant should be force-fed to the heat exchanger in its liquid phase close to the refrigerant's liquid saturation condition, i.e., close to its boiling point at a given pressure. By enforcing a pressure drop through a porous medium in the heat exchanger, the refrigerant enters a two-phase region in which the temperature of the fluid is dependent only on its pressure. In the pressure-enthalpy diagram shown in FIG. 1, the refrigerant feed is at the thermodynamic condition A in a liquid phase region 101. This feed flow is subject to a pressure drop that causes the pressure to reduce and the enthalpy to increase, shifting the refrigerant to position B, a point representing a two-phase mixture in region 102 of the diagram. Upon exiting the heat exchanger, the refrigerant may move into its gas phase region 103.

The refrigerant may be selected in relation to the temperature the heat source is to be maintained at. With reference to FIG. 1, the thermodynamic operating point of the system should be located close to the sloped liquid saturation line and in an area where the slope is between horizontal and vertical.

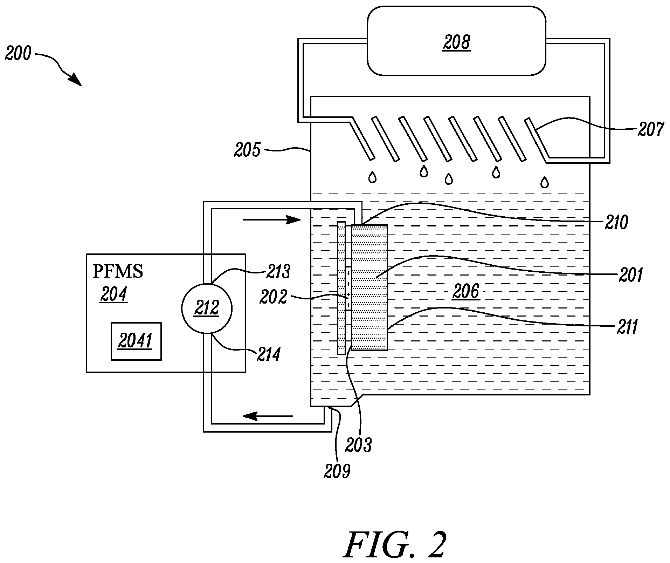

An example cooling system 200 is illustrated schematically in FIG. 2. The cooling system architecture is similar to that of a conventional immersion cooling system, but with the addition of a heat exchanger 201 immersed in a liquid refrigerant bath. Components 202 to be cooled are in contact with a first surface 203 of the heat exchanger 201. The heat exchanger 201 is fed with liquid refrigerant by forced refrigerant flow supplied by a pressure and flow management system (PFMS) 204.

The PFMS 204, which includes or is associated with a control unit 2041, may use information from pressure and temperature sensors (not shown in FIG. 2) to manage and control the pressure and flow rate in order to maintain the feed of refrigerant into the heat exchanger 201 in its liquid phase and close to its boiling point.

The cooling system 200 comprises a tank 205 containing a liquid refrigerant 206, within which the heat exchanger and electronic components 202 are immersed. Gaseous phase refrigerant condenses on a condenser 207 and returns to the liquid phase. The condenser 207 is cooled by a cooler 208, which recirculates a cooling fluid through the condenser 207.

The PFMS 204 receives liquid refrigerant from the tank 205 via a liquid outlet 209, recirculates and provides the liquid refrigerant to an inlet 210 of the heat exchanger using a refrigerant pump 212. The refrigerant pump 212 has an inlet 214 connected to the liquid outlet 209 of the tank 205 to receive liquid refrigerant 206 from the tank 205 and an outlet 213 connected to the fluid inlet 210 of the heat exchanger 201. The liquid refrigerant passes from the pump 212 through the heat exchanger 201 and exits via an external surface 211 into the tank 205.

The cooler 208 may include a pump for circulating the cooling fluid through the condenser 207 and its own heat exchanger for removing heat from the cooling fluid. Through control of the cooler 208 (e.g., the speed of the pump to control mass flow rate, and the temperature of the cooling fluid), a rate of heat transfer from the refrigerant 206 to the condenser 207 may be controlled. The cooler 208 may be controlled by the control unit 2041 or another controller in communication with the control unit 2041.

As noted above, the control unit 2041 controls the PFMS 204 to maintain the temperature of the component within a desired range. In particular, the control unit 2041 controls a speed of the PFMS pump 212 to generate a defined mass flow rate. Optionally, the control unit 2041 may also control the condenser cooling circuit 207, 208 (e.g., condenser pump speed and/or cooling liquid temperature) to control the rate of heat transfer from the refrigerant 206 to the condenser 207. In doing so, the control unit 2041 may keep the liquid feed to the evaporator 201 close to its liquid saturation line. Referring to the diagram in Fig. 1, the control unit 2041 may make sure point A should be maintained in the liquid-phase region but close to the left blue line of the two-phase region.

The control unit 2041 selects the mass flow rate and the rate of heat transfer between the refrigerant 206 to the condenser 207 to achieve a target downstream pressure of the evaporator 201 (the tank pressure in the embodiment of FIG. 2). The downstream pressure (e.g., the tank pressure) determines an evaporation temperature of the fluid because pressure and temperature are dependent on each other in the two-phase region. Thus, controlling the downstream pressure provides effective control the component temperature. Referring to FIG. 1, by controlling the mass flow rate of the PFMS 204 and the rate of heat transfer between the refrigerant 206 to the condenser 207, the control unit 2041 has full authority to determine where point A should be. This provides full control over the working temperature of the cooled component 202.

The component temperature will depend, amongst other things, on the component power dissipation so there should be a target parameter in the control logic that takes account of the component power dissipation. If the logic is open-loop, the system 200 may, prior to use, be characterised and a control law established that links, e.g., the power demand of a power electronics component, and the dissipation to the desired location of point A. If the logic is closed-loop, the control unit 2041 should receive one or more temperature readings of the component 202 or temperature readings from the component-evaporator interface.

By way of a specific example, consider an insulated tank 205 with a fluid 206 inside. Generally speaking, the fluid 206 may be in the liquid phase, the gaseous phase or a mix of the two with a certain quality (a property of the vapour/liquid mix, that represents the saturated vapour density divided by average density of the mix). The state of the system depends on the amount of internal energy it has, which determines the temperature, the pressure and the densities of the vapour and the liquid (noting that only the densities are different between the two phases). Consider the case of a mix of phases.

The PFMS 204 extracts a certain mass flow rate of liquid from the tank 206 and, via the evaporator 201, reintroduces the same mass flow rate as liquid and vapour mix of a certain quality. Returning two phases to the tank 205 introduces energy (enthalpy) back into the tank 205 at a certain rate. Therefore, to control the temperature of the component 202, the control unit 2041 should control the condenser circuit 207, 208 so that it extracts energy at the same rate. With these heat exchanges the pressure within the vessel will depend on the overall internal energy.

Explained another way, if the PFMS 204 extracts a certain quantity of liquid and returns it to the tank 205 as a mix, the mix with have a lower average density than the extracted liquid. This will increase the pressure within the tank 205, and this should be compensated by increasing the density of part of the vapour by condensing it back to liquid. To do so, the control unit 2041 should control the condenser circuit 207, 208 so that it condenses vapour back to liquid at a compensating rate. The pressure will depend on the average density of the fluid contained within the tank 205.

If the mass flow rate of liquid extracted by the PFMS 204 is increased (i.e., if the speed of the pump 212 increases with the same quality of the case above), maintaining the same internal energy (or same average density) within the vessel 205 requires that the condenser 207 condenses vapour at a faster rate. Thus, the control unit 2041 should control the condenser circuit 207, 208 accordingly. Increasing the mass flow rate at constant quality means introducing more power into the vessel in proportion to the mass flow rate increase (this comes from the component dissipated heat rate).

The pressure loss across the evaporator 201 may introduce some control complexity because it links the quality of the mix reintroduced to the vessel 205 to the mass flow rate of the pump 212 and the rate of heat generation by the component 202. If the rate of heat generation by the component 202 increases, the speed of the pump 212 should be increased to increase the mass flow rate. However, this will introduce more power to the vessel 205, so the condenser cooling circuit 207, 208 should also be controlled, by increasing the rate of heat transfer, to compensate.

It is noted that although an insulated system has been considered in the above explanation for convenience, this assumption may be relaxed without any significant change to the logic of the control unit 2041.

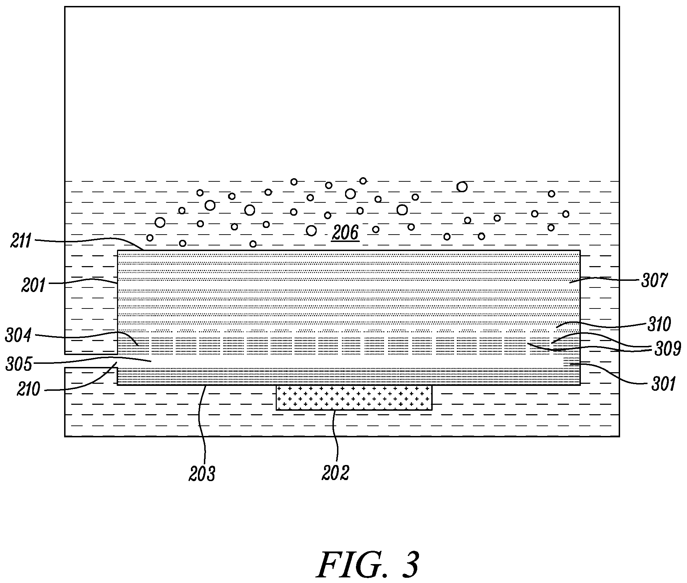

A more detailed schematic view of an example heat exchanger or evaporator 201 is illustrated in FIG. 3 in a horizontal position. The heat exchanger 201 comprises a first part 301 and a second part 307. The first part 301 has a first surface 203 connected to a component 202 to be cooled and a second opposing surface 304. The first part 301 has a fluid flow channel 305 extending from a fluid inlet 210 through the first part 301 between the first and second surface 203, 304.

The second part 307 extends from the second surface 304 to an external third surface 211 of the heat exchanger 201. The second part 307 has an open-cell porous structure that is in fluid communication with the fluid flow channel 305 such that refrigerant fluid flowing through the fluid flow channel 305 enters into and filters through the second part 307 and exits the heat exchanger 201 at the external third surface 211.

Both the first and second parts 301, 307 are composed of a thermally conductive, e.g., metallic, material. Example materials include copper, aluminium or alloys thereof. The first part 301 may be solid or non-porous, while the second part 307 has an open-cell porous structure that permits fluid flow through the second part 307. The second surface 304 is an internal interface between the first and second parts 301, 307. The first and second parts 301, 307 may be of unitary construction, i.e., made as a single piece, or may be formed from two parts joined together along the second surface 304.

A plurality of fluid passages 309 may be provided that connect the fluid flow channel 305 to the second part 307 of the heat exchanger 201. The fluid passages 309 distribute the refrigerant in liquid phase across the second part 307. Part of the heat from the component 202 will be exchanged with the refrigerant within the fluid passages 309. Further heat will be transferred by the heat exchanger to the porous second part 307.

The porosity characteristic of the second part is in the form of open-cell pores that allow the refrigerant to flow through the second part 307 in liquid or gas phase before exiting the heat exchanger 201 via the external third surface 211.

The refrigerant flow from the fluid passages 309 may pass into the second part 307 via branching diffusion channels 310 extending into the second part 307. The diffusion channels 310 increase the surface area of the fluid passages 309 to diffuse the fluid flow channel 305 into the second part 307. The thermally conductive porous second part 307 causes the refrigerant to incur a pressure drop and to exchange heat with the refrigerant.

Optionally, nozzles may be placed in (or manufactured into) the fluid passages 309, the nozzles configured to produce an isenthalpic pressure drop in the liquid refrigerant. The total pressure drop will be a combination of the drop produced by the nozzles and the porous second part 307. The function of each nozzle is equivalent to that of a coil or an isenthalpic valve in a refrigeration cycle, which is to cause a phase change of a fluid through an isenthalpic process by introducing a concentrated pressure loss. This function is shared with the porous element (in that case the pressure loss is more distributed), which also undertakes two heat transfer functions: i) to exchange heat with the fluid and ii) to conduct the heat away. To optimise the design of the porous element to perform its heat transfer functions, nozzles can be used to allow more design freedom. The form of each nozzle may vary and may for example be a de Laval (convergent-divergent) nozzle or a diaphragm with a hole having sharp, chamfered or rounded edges. In a general aspect, each nozzle may provide a constriction in the fluid passage 309.

The two effects of pressure drop and heat exchange will cause the refrigerant to change phase from liquid in the fluid flow channel 305 into liquid and gas. The refrigerant will then exit the porous element to enter the tank in gas phase or in a mixture of liquid and gas phases.

In an alternative arrangement, the heat exchanger 201 may be disposed in a casing enclosing the first and second parts 301, 307. The casing may be hermetically sealed around the second part 307 of the heat exchanger and with an outlet to allow refrigerant to be recirculated. The component 202 to be cooled may be attached to an exterior surface of the casing.

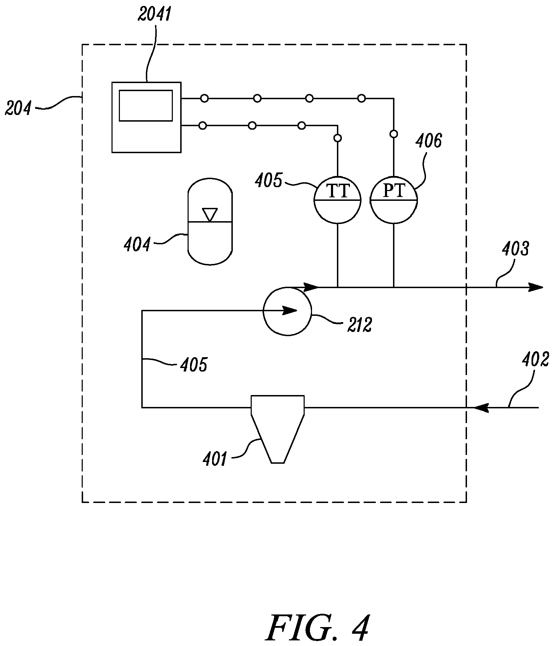

A more detailed schematic diagram of an example PFMS 204 is illustrated in FIG. 4. A gas-liquid separator 401 receives fluid from the tank 205, which may be a mixture of liquid and gas, via an inlet line 402. The gas-liquid separator 401 may for example operate to centrifugally separate liquid from gas in the refrigerant received via the inlet line 402. The gas-liquid separator 401 is connected to provide liquid to the pump 212, which pumps liquid via an outlet line 403 to the heat exchanger 201. An accumulator 404 may be connected to a line 405 connecting the gas-liquid separator 401 and pump 212 to ensure that there is sufficient liquid being supplied to the pump 212.

Temperature and pressure sensors 405, 406 are connected to the outlet line 403 and provide respective temperature and pressure readings to a control unit 2041. The control unit 2041 controls operation of the pump 212 so that the temperature and pressure of the liquid being provided to the heat exchanger 201 is within predefined limits. The control unit 2041 in effect ensures that the liquid refrigerant being supplied to the heat exchanger 201 is around point A indicated in FIG. 1 to optimise cooling efficiency through the transformation to point B as the refrigerant passes into and through the heat exchanger 201 and to control the working temperature of the components to be cooled.

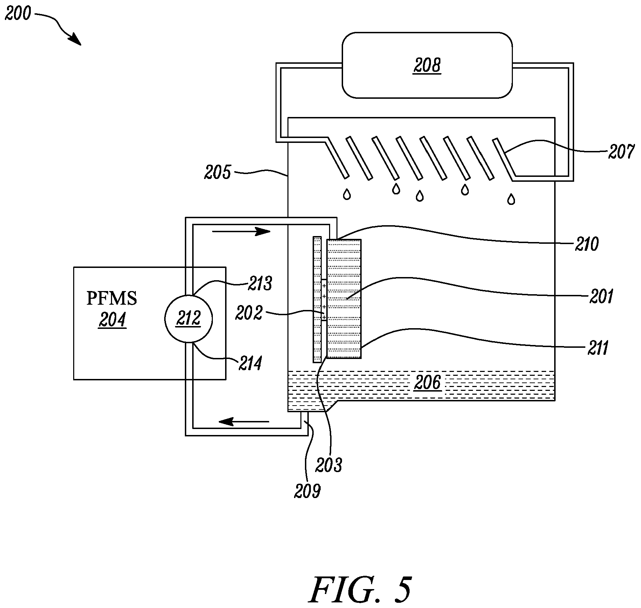

While the heat exchanger 201 in the cooling system 200 as illustrated in FIG. 2 is fully immersed in the liquid refrigerant 206, in other configurations the tank 205 may contain a smaller proportion of liquid refrigerant 206. FIG. 5 illustrates the cooling system 200 in a configuration where the liquid refrigerant 206 is below the level of the heat exchanger 201. Operation of the heat exchanger 201 is similar to the case where the heat exchanger 201 is fully or partially immersed in the liquid refrigerant 206, but the proportion of liquid to vapour exiting from the heat exchanger 201 will differ depending on the degree of phase change chosen by the designer. In an alternative non-immersed application of the heat exchanger, this may act as an evaporator of a reversed Rankine cycle.

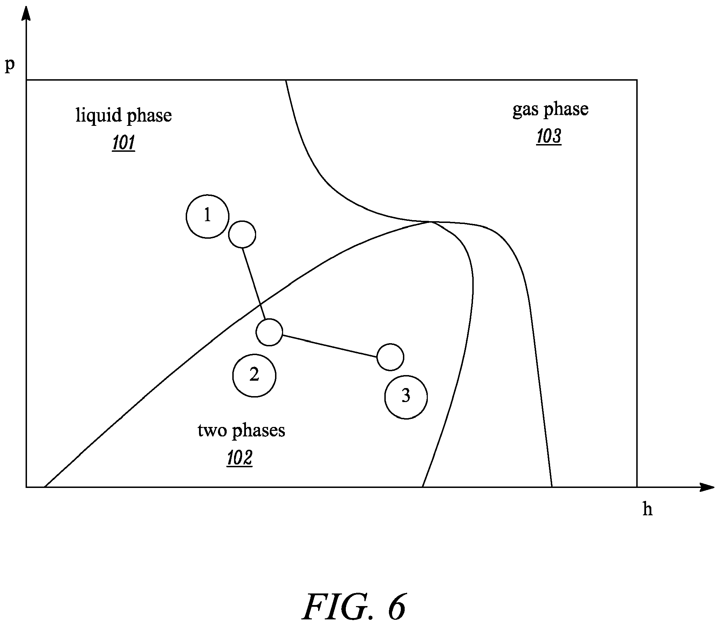

FIG. 6 illustrates the refrigerant at different points in the heat exchanger 201. The refrigerant is fed into the heat exchanger 201 at the thermodynamic conditions of point 1. The refrigerant then flows through the fluid flow channel 305 and into the porous second part 307 at point 2. The reduction in pressure and increase in enthalpy causes the refrigerant to enter the two-phase region 102, which results in an exchange of heat with the heat exchanger 201. The refrigerant then loses further pressure as it passes through the second part 307 and exits the heat exchanger 201 at point 3, which corresponds to the tank pressure.

The first and second parts 301, 307 of the heat exchanger 201 (FIG. 3) may be manufactured in various ways. In a first process, the two parts 301, 307 may be produced in one piece through a sintering process, with internal cavities forming the fluid flow channel 305, the fluid passages 309 and diffusion channels 310 formed using sacrificial cores that are etched away after sintering. The first part 301 may be sintered to a high or full density, while the second part 307 may be sintered to partial density, for example by incorporating a second phase of material that is removed during the sintering process and leaves behind the required open-cell porous structure.

In a second process, the two parts 301, 307 may be produced in a single piece via 3D printing, which can form the fluid flow channel 305, passages 309, distribution channels 310 and porous second part 307 directly. Additive layer manufacturing may be used to form the first and second parts as a single piece, for example by a process such as direct laser metal sintering, a process that is currently well established in the industry. The porous structure of the second part may be achieved by using a sintering process that uses a sacrificial material to form the cavities in the porous structure. An example of such a process is described by Zhao et al in "Lost carbonate sintering process for manufacturing metal foams", Scripta Materialia Volume 52, Issue 4, February 2005, Pages 295-298. Another example is described by Wan et al in "Fabrication, properties, and applications of open-cell aluminum foams: A review", Journal of Materials Science & Technology Volume 62, 30 January 2021, Pages 11-24. Open-cell metal foams are currently used in a number of specialised products for applications such as heat exchangers, catalyst supports and biomaterial implants.

In a third process, the heat exchanger 201 may be formed from two pieces. The fluid flow channel 305 and fluid passages 309 may be machined in a first solid piece to form the first part 301. The porous second part 307 may then be machined to form the distribution channels 310 and the first and second parts 301, 307 joined together, for example by a diffusion bonding or brazing process.

The heat exchanger 201 as described herein is particularly suitable for liquid immersion cooling applications but may also be used for a vapour compression cycle cooling system, in which the heat exchanger operates as an isenthalpic valve, evaporator and vapour superheater. The geometry of the nozzles in the heat exchanger, as described above, may be configured to provide a controlled pressure drop across the heat exchanger.

## Claims

1. A heat exchanger (201) for a cooling system (200), the heat exchanger (201) comprising:
a first part (301) having a first surface (203) for connecting to a component (202) to be cooled and a second opposing surface (304), the first part (301) having a fluid flow channel (305) extending from a fluid inlet (210) through the first part (301) between the first and second surfaces (203, 304);
a second part (307) extending from the second surface (304) to an external third surface (211), the second part (307) having an open-cell porous structure in fluid communication with the fluid flow channel (305) such that fluid flowing through the fluid flow channel (305) passes into the second part (307) and exits the heat exchanger (201) at the external third surface (211).

2. The heat exchanger of claim 1, wherein the fluid flow channel (305) extends from the fluid inlet (210) in a direction parallel to the first and second surfaces (203, 304).

3. The heat exchanger (201) of claim 1 or claim 2, comprising a plurality of fluid passages (309) connecting the fluid flow channel (305) to the second part (307).

4. The heat exchanger (201) of claim 3, wherein each of the plurality of fluid passages (309) comprises a branching diffusion channel (310) extending into the second part (307).

5. The heat exchanger (201) of claim 3 or claim 4, wherein a diameter of each of the fluid passages (309) is smaller than a diameter of the fluid flow channel (305).

6. The heat exchanger (201) of any one of claims 3 to 5, wherein each of the fluid passages (309) comprises a nozzle configured to cause an isenthalpic pressure drop in liquid refrigerant passing through the nozzle.

7. The heat exchanger (201) of claim 6, wherein the nozzle is in the form of a convergent-divergent nozzle.

8. A cooling system (200) comprising:
a tank (205) for containing a refrigerant liquid (206);
a heat exchanger (201) according to any one of claims 1 to 7 disposed in the tank (205);
a refrigerant pump (212) having an outlet (213) connected to the fluid inlet (210) of the heat exchanger (201) and an inlet (214) connected to a liquid outlet (209) of the tank (205) to receive liquid refrigerant from the tank (205); and
a component (202) to be cooled connected to the first surface (203) of the heat exchanger (201).

9. The cooling system (200) of claim 8, further comprising a control unit (2041) configured to control a mass flow rate delivered by the pump (212).

10. The cooling system (200) of claim 8 or claim 9, further comprising a condenser (207) disposed in the tank (205) and connected to a cooler (208) arranged to extract heat from the tank (205) via the condenser (207), and a control unit (2041) configured to control operation of the condenser (207) to control a rate of heat transfer between the liquid refrigerant (206) and the condenser (207).

11. A method of operating a cooling system (200) to control a temperature of a component (202), the system comprising:
a heat exchanger (201) according to any one of claims 1 to 7;
a refrigerant pump (212) having an outlet (213) connected to the fluid inlet (210) of the heat exchanger (201); and
a component (202) to be cooled connected to the first surface (203) of the heat exchanger (201),
the method comprising operating the refrigerant pump (212) to pump refrigerant liquid (206) into the heat exchanger (201).

12. The method of claim 11, wherein the heat exchanger (201) is disposed in a tank (205) containing the refrigerant liquid (206), the refrigerant pump (212) having an inlet connected to a liquid outlet (209) of the tank (205) to receive refrigerant liquid (206) from the tank (205), and wherein the cooling system comprises a condenser (207) disposed in the tank (205) and connected to a cooler (208) operating to extract heat from the tank (205) via the condenser (207), and a control unit (2041), the method comprising:
responsive to an increase in a rate of heat generation by the component (202), the control unit (2041) increasing a mass flow rate delivered by the pump (212) and increasing a rate of heat transfer between the condenser (207) and the refrigerant liquid (206).

13. The method of claim 12, wherein the control unit (2041) is configured to control the mass flow rate delivered by the refrigerant pump (212) and the rate of heat transfer between the condenser (207) and the refrigerant liquid (206) to control a downstream pressure of the heat exchanger (201) and thereby control an evaporation temperature of the refrigerant liquid (206).

14. The method of any one of claims 11 to 13, wherein the cooling system comprises a temperature sensor (405) and a pressure sensor (406) connected to measure temperature and pressure of liquid in an outlet line (403) connecting the pump (212) to the heat exchanger (201), and a control unit (2041) that receives temperature and pressure readings from the temperature and pressure sensors (405, 406) and controls operation of the pump (212).

15. The method of claim 14, wherein the control unit (2041) controls operation of the pump to maintain the refrigerant in the outlet line (403) in liquid phase (101).
